# EUROPÄISCHE PATENTSCHRIFT

(11) **EP 0 715 107 B1**
(45) Veröffentlichungstag und Bekanntmachung des Hinweises auf die Patenterteilung: **07.06.2000**
(21) Anmeldenummer: 95118542.0
(22) Anmeldetag: 24.11.1995
(51) Int. Cl.: F16K 31/06, H01R 13/66, H05K 1/14, H05K 7/14

(54) **Aufsteckbare Anschlussvorrichtung für elektrische Geräte**
Connecting device pluggable into electrical apparatus
Dispositif de connexion enfichable sur des appareils électriques

(30) Priorität: 02.12.1994 DE 9419344 U
(43) Veröffentlichungstag der Anmeldung: 05.06.1996
(73) Patentinhaber: Bürkert Werke GmbH & Co., D-74653 Ingelfingen (DE)
(72) Erfinder: Hettinger, Gerhard, D-74653 Ingelfingen (DE)
(74) Vertreter: Degwert, Hartmut, Dipl.-Phys.

(56) Entgegenhaltungen:
- EP-A- 0 101 527
- DE-A- 4 207 850
- DE-A- 4 309 695
- DE-C- 3 507 696
- DE-U- 9 205 977

## Beschreibung

Die Erfindung betrifft eine aufsteckbare Anschlußvorrichtung für elektrische Geräte, insbesondere Magnetventile, mit einem Gehäuse, einer darin untergebrachten elektrischen/ elektronischen Schaltung, einem an die Schaltung angeschlossenen Kabel und Steckkontakten zum Anschließen an das Gerät.

Anschlußvorrichtungen dieser Art werden dazu verwendet, elektrische Geräte mit einem Anschlußkabel zu verbinden. Um diese Anschlußvorrichtungen mit geringen Abmessungen ausführen zu können, ist nach dem Stand der Technik die in dem Gehäuse der Anschlußvorrichtung vorgesehene elektrische oder elektronische Schaltung vergossen, wobei die Verbindung des elektrischen Anschlußkabels mit der Schaltung gleich mit eingegossen wird. Durch das Vergießen der Schaltung können auch bei geringen Abmessungen der Anschlußvorrichtung Luft- und Kriechstrecken vermieden werden.

Das Vergießen der Schaltung der Anschlußvorrichtung mit dem Anschlußkabel hat zur Folge, daß nur komplett mit dem Kabel vorgefertigte Anschlußvorrichtungen produziert werden können. Um dennoch bei der Auswahl der Anschlußvorrichtung flexibel zu sein, müssen die Anschlußvorrichtungen mit verschiedenen eingebauten Schaltungen und mit unterschiedlichen Kabellängen gefertigt werden, wobei alle diese verschiedenen Ausführungen auch auf Lager gehalten werden müssen. Dies führt zu einer großen Vielfalt von Anschlußvorrichtungen und somit zu erhöhten Produktions- und Lagerkosten. Ein weiterer Nachteil der Anschlußvorrichtungen nach dem Stand der Technik besteht darin, daß z.B. bei einem Wechsel der Beschaltungsart ein Austausch der elektrischen oder elektronischen Schaltungen nur dadurch möglich ist, daß die gesamte Anschlußvorrichtung zusammen mit dem Anschlußkabel ausgetauscht wird.

Aus der DE 35 07 696 C1 ist eine gattungsgemäße Vorrichtung bekannt, bei der ein mit einem Anschlußkabel versehener Winkelstecker mit Steckkontakten in einem Steckgehäuse untergebrachte verschaltete elektrische Bauelemente aufweist. Um eine vormontierte Einheit aus einer Leiterplatte, einer Trägerplatte und zwei Abdeckungen wird ein Anschlußgehäuse gespritzt. Nachträgliche Änderungen sind nach dem Umspritzen nicht möglich.

Durch die Erfindung wird eine Anschlußvorrichtung geschaffen, bei der die elektrische/elektronische Schaltung und das Anschlußkabel mit einer größeren Flexibilität miteinander kombinierbar sind.

Dies wird bei einer Anschlußvorrichtung der oben genannten Art dadurch erreicht, daß die Schaltung als austauschbarer Modul aufgebaut, auswechselbar in das Gehäuse eingesetzt, und aus zwei einander im Abstand gegenüberliegenden Leiterplatten und dazwischen senkrecht angeordneten Bauteilen aufgebaut ist. Die Modulbauweise ermöglicht, die Schaltung und/oder das Anschlußkabel der Anschlußvorrichtung unabhängig von den anderen Bauelementen auszutauschen, während die besondere Ausbildung der Schaltung zu einem vergleichsweise großen Abstand zwischen den Anschlüssen der Bauteile führt, so daß auf ein Vergießen der Schaltung verzichtet werden kann.

Vorzugsweise weist das Gehäuse einen unter Zwischenfügung einer Dichtung aufgesetzten und verschraubten Deckel auf. Auf diese Weise wird ein dichtes Gehäuse erhalten, das dennoch einen Zugang zu der in dem Gehäuse angeordneten Schaltung ermöglicht.

Vorzugsweise sind die Leiterplatten mit Aussparungen für den Durchtritt von Verschraubungselementen versehen. Auf diese Weise kann das Gehäuse mit nur einer mittig angeordneten Verschraubung verschlossen werden.

Vorzugsweise weist die Anschlußleiste schraubbare Klemmelemente auf. Die Verwendung von schraubbaren Klemmelementen ermöglicht ein lösbares Verbinden des Anschlußkabels mit der Schaltung mittels einfacher Schraubwerkzeuge.

Die bevorzugte Ausführungsform der Erfindung wird nachfolgend unter Bezugnahme auf die Zeichnung beschrieben. In dieser zeigen:
- Fig. 1: eine Anschlußvorrichtung in einer Explosionsansicht;
- Fig. 2: die Anschlußvorrichtung von Fig. 1 in einer Seitenansicht, wobei das Gehäuse entfernt ist; und
- Fig. 3: eine Leiterplatte der Anschlußvorrichtung von Fig. 2 in einer schematischen Draufsicht.

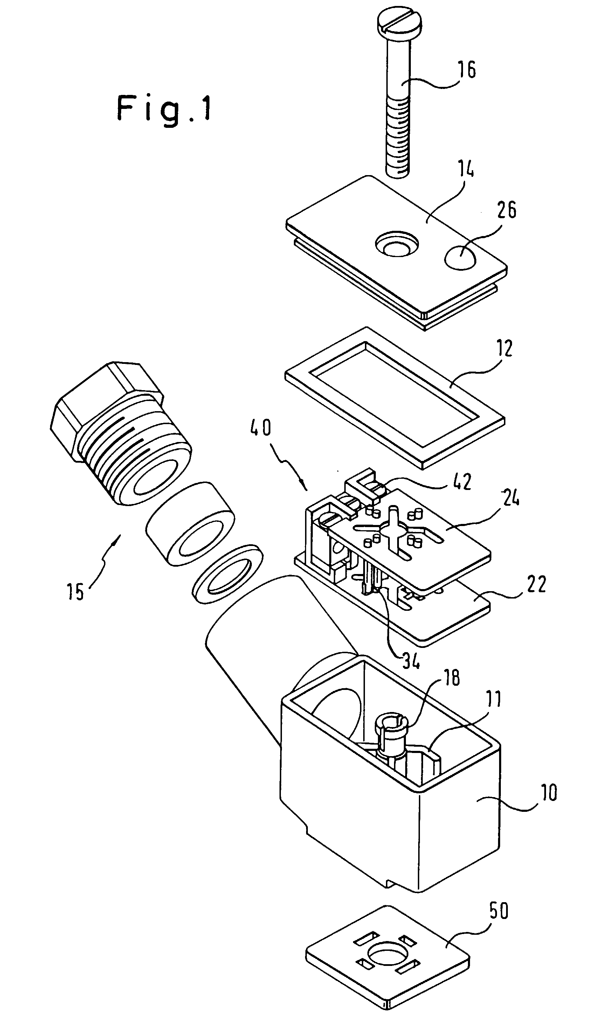

In Fig. 1 ist eine erfindungsgemäße Anschlußvorrichtung dargestellt, die im wesentlichen aus einem Gehäuse 10, 12, 14 und einer elektrischen oder elektronischen Schaltung 22, 24, 32 besteht.

Das Gehäuse besteht aus einem Gehäusebasisteil 10, mit dem unter Zwischenfügung einer Dichtung 12 ein Deckel 14 verschraubt werden kann, vorzugsweise durch eine aus einer Schraube 16 und einer Gewindebuche 18 bestehenden Verschraubung. Der Durchtritt eines (nicht dargestellten) Anschlußkabels in das Gehäuseinnere ist mit einer Dichtung und einer Verschraubung versehen, die als Gesamtheit mit dem Bezugszeichen 15 versehen sind. Der Deckel 14 ist mit einer Kuppe 26 versehen, in die bei komplett montierter Anschlußvorrichtung eine optional an der Schaltung vorgesehene Leuchtdiode hineinragen kann, so daß sie von allen Seiten sichtbar ist.

In das Gehäuseinnere ist eine elektrische oder elektronische Schaltung eingesetzt, die aus zwei im Abstand voneinander angeordneten Leiterplatten 22, 24 sowie senkrecht zwischen diesen angeordneten Bauteilen 32 besteht. Auf einer der Leiterplatten ist ferner für das Anschließen des Anschlußkabels eine Anschlußleiste 40 vorgesehen, die mit schraubbaren Klemmelementen 42 versehen ist, um das Anschlußkabel leicht von der Schaltung lösen zu können, z.B. bei einem Austausch der Schaltung oder für den Anschluß eines Anschlußkabels anderer Länge.

Im Gehäuseinneren sind Trennwände 11 vorgesehen, die allgemein sternförmig von der Gehäusemitte nach außen angeordnet sind. Diese Trennwände 11 durchqueren bei eingebauter Schaltung in den Leiterplatten 22, 24 ausgebildete Schlitze und haben die Aufgabe, die Bauteile der Schaltung gegeneinander anzuschirmen und die Kriechstrecken zu vergrößern.

Auf seiner Unterseite weist das Gehäuse 10 (nicht dargestellte) Durchtrittsöffnungen für Steckfahnen eines elektrischen Geräts auf, die für eine Verbindung mit der Anschlußvorrichtung in Steckkontakte 34 eingreifen können, die auf der vom Boden des Gehäuses abgewandten Leiterplatte 24 befestigt und kontaktiert sind und durch Aussparungen in der gegenüberliegenden Leiterplatte 22 hindurchragen. Die Steckkontakte 34 sind ferner gegenüber den Durchtrittsöffnungen des Gehäuses angeordnet. Zwischen der Anschlußvorrichtung und dem anzuschließenden elektrischen Gerät ist eine Dichtung 50 angeordnet, die mit Durchgangsöffnungen für die Steckfahnen des elektrischen Geräts versehen ist, wobei die Anordnung der Durchgangsöffnungen mit der Anordnung der Durchtrittsöffnungen des Gehäuses 10 übereinstimmt. Diese Dichtung 50 dichtet sowohl die Steckfahnen des elektrischen Geräts als auch die Durchtrittsöffnungen des Gehäuses gegen die Umwelt ab.

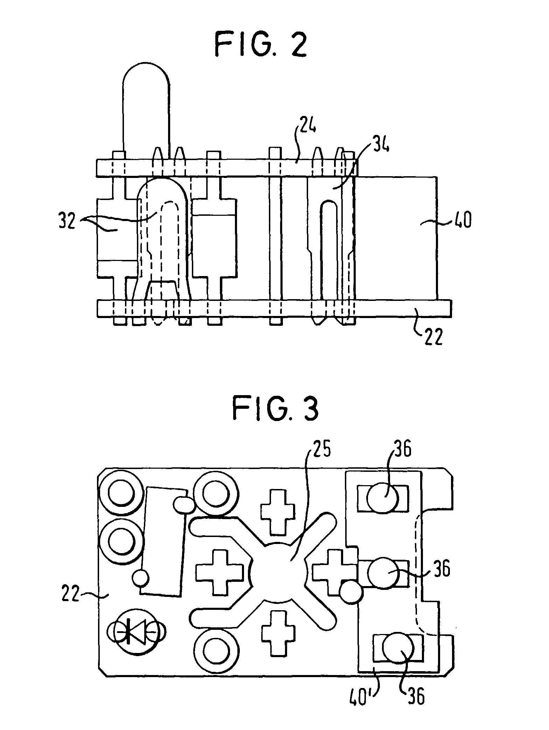

In Fig. 2 sind deutlicher die beiden Leiterplatten 22, 24 zu erkennen, zwischen denen sich senkrecht angeordnet die Bauteile 32 der Schaltung der Anschlußvorrichtung sowie die Steckkontakte 34 befinden. Durch die senkrechte Anordnung der Bauteile ist es insbesondere möglich, bei geringen Abmessungen der Anschlußvorrichtung und der Schaltung vergleichsweise große Abstände zwischen den Anschlüssen der Bauteile auszubilden, so daß ein Vergießen der Schaltung nicht notwendig ist. Auf der Leiterplatte 22 ist ferner die Klemmleiste 40 angeordnet.

In Fig. 3 ist diese Leiterplatte 22 deutlicher zu sehen, auf der die mit Anschlußkontakten 36 der Schaltung verbundene Klemmleiste 40 vorgesehen ist, von der in dieser Figur nur der Umriß 40' dargestellt ist. In dieser Figur ist auch die Aussparung 25 in der Leiterplatte 22 zu sehen, durch die sich die Verschraubung 16, 18 des Gehäuses hindurch erstreckt.

## Patentansprüche

1. Aufsteckbare Anschlußvorrichtung für elektrische Geräte, insbesondere Magnetventile, mit einem Gehäuse (10, 12, 14), einer darin untergebrachten elektrischen/elektronischen Schaltung (22, 24, 32), einem an die Schaltung angeschlossenen Kabel und Steckkontakten (34) zum Anschließen an das Gerät, dadurch gekennzeichnet, daß die Schaltung (22, 24, 32) als austauschbarer Modul aufgebaut, auswechselbar in das Gehäuse (10, 12, 14) eingesetzt und aus zwei einander im Abstand gegenüberliegenden Leiterplatten (22, 24) und dazwischen senkrecht angeordneten Bauteilen (32) aufgebaut ist.

2. Anschlußvorrichtung nach Anspruch 1, dadurch gekennzeichnet, daß das Gehäuse (10, 12, 14) einen unter Zwischenfügung einer Dichtung (12) aufgesetzten und verschraubten Deckel (14) aufweist.

3. Anschlußvorrichtung nach Anspruch 1 oder 2, dadurch gekennzeichnet, daß die Leiterplatten (22, 24) mit Aussparungen (25) für den Durchtritt von Verschraubungselementen (16, 18) versehen sind.

4. Anschlußvorrichtung nach Anspruch 2 oder 3, dadurch gekennzeichnet, daß wenigstens eine der Leiterplatten (22, 24) eine Anschlußleiste (40) für das Anschließen des Kabels aufweist.

5. Anschlußvorrichtung nach Anspruch 4, dadurch gekennzeichnet, daß die Anschlußleiste (40) schraubbare Klemmelemente (42) aufweist.

6. Anschlußvorrichtung nach einem der Ansprüche 2 bis 5, dadurch gekennzeichnet, daß die Steckkontakte (34) in der vom Boden des Gehäuses abgewandten Leiterplatte (24) befestigt und kontaktiert sind und durch Aussparungen in der gegenüberliegenden Leiterplatte (22) hindurchragen.

## Claims

1. A plug-on connecting device for electric apparatus, in particular solenoid valves, comprising a housing (10, 12, 14), an electric/electronic circuit (22, 24, 32) accommodated therein, a cable connected to the circuit, and plug contacts (34) for connection to the apparatus, characterized in that the circuit (22, 24, 32) is constructed in the form of an interchangeable module, is inserted in the housing (10, 12, 114) so as to be exchanged, and is constructed from a pair of circuit boards (22, 24) arranged opposite each other at a distance and components (32) disposed perpendicularly in between.

2. The connecting device according to claim 1, characterized in that the housing (10, 12, 14) includes a cap (14) placed and screwed thereon, with a seal (12) interposed.

3. The connecting device according to claim 1 or 2, characterized in that the circuit boards (22, 24) are provided with recesses (25) for screw connection members (16, 18) to pass therethrough.

4. The connecting device according to claim 2 or 3, characterized in that at least one of the circuit boards (22, 24) has a terminal strip (40) for connecting the cable.

5. The connecting device according to claim 4, characterized in that the terminal strip (40) includes screw-type clamping members (42).

6. The connecting device according to any of claims 2 to 5, characterized in that the plug contacts (34) are mounted and bonded in the circuit board (24) facing away from the bottom of the housing and protrude through recesses provided in the opposite circuit board (22).

## Revendications

1. Dispositif de connexion embrochable pour appareils électriques, notamment pour électrovannes, comprenant un boîtier (10, 12, 14), un circuit électrique-électronique (22, 24, 32) logé dans le boîtier, un câble connecté au circuit et des contacts à broche (34) pour le raccordement à l'appareil, caractérisé en ce que le circuit (22, 24, 32) est construit sous la forme d'un module interchangeable, est encastré dans le boîtier (10, 12, 14) de facon interchangeable et est composé de deux circuits imprimés (22, 24) opposés face à face à un certain écartement et de composants (32) disposés perpendiculairement entre les circuits imprimés.

2. Dispositif de connexion selon la revendication 1, caractérisé en ce que le boîtier (10, 12, 14) comprend un couvercle (14) vissé et monté avec interposition d'une garniture d'étanchéité (12).

3. Dispositif de connexion selon l'une des revendications 1 ou 2, caractérisé en ce que les circuits imprimés (22, 24) sont munis d'évidements (25) pour le passage d'éléments de boulonnage (16, 18).

4. Dispositif de connexion selon l'une des revendications 2 ou 3, caractérisé en ce que les circuits imprimés (22, 24) présente une plaque à bornes (40) pour la connexion du câble.

5. Dispositif de connexion selon la revendication 4, caractérisé en ce que la plaque à bornes (40) comprend des éléments de bornes (42) pouvant être vissés.

6. Dispositif de connexion selon l'une des revendications 2 à 5, caractérisé en ce que les contacts à broche (34) sont fixés et mis en contact dans le circuit imprimé (24) qui est à l'opposé du fond de boîtier et sont passés à travers des évidements ménagés dans le circuit imprimé (22) qui lui est opposé.
